# FASCICULE DE BREVET EUROPEEN

(11) **EP 0 575 912 B1**
(45) Date de publication et mention de la délivrance du brevet: **03.11.1999**
(21) Numéro de dépôt: 93109783.6
(22) Date de dépôt: 18.06.1993
(51) Int. Cl.: A47J 42/56, G08B 29/14, H03K 17/94

(54) **Procédé et dispositif de vérification du fonctionnement d'un système de détection à capteur**
Verfahren und Vorrichtung zum Überprüfen der Funktionstüchtigkeit eines Meldesystems mit Aufnehmer
Method and device for verifying functioning of a detection system with sensor

(30) Priorité: 22.06.1992 FR 9207595
(43) Date de publication de la demande: 29.12.1993
(73) Titulaire: Moulinex S.A., 13123 Cormelles-le-Royal (FR)
(72) Inventeur: Arroubi, Mustapha, F-14120 Lully (FR); Lalande, Michel Georges Eugène, F-14210 Missy (FR)
(74) Mandataire: May, Hans Ulrich, Dr.

(56) Documents cités:
- EP-A- 0 316 973
- EP-A- 0 327 082
- EP-A- 0 440 051
- DE-A- 3 700 617
- FR-A- 2 485 774
- GB-A- 2 110 386
- GB-A- 2 127 603
- US-A- 4 990 895

## Description

La présente invention telle qu'elle est oléfinie dans les revendications se rapporte aux systèmes de détection à capteur commandé par un émetteur et comportant une centrale de commande électronique dont certaines broches sont adaptées à piloter un circuit de commande et dont au moins une broche dite Pᵢ est reliée au capteur qui peut prendre grâce à une source d'alimentation V_{cc} soit un état passant lorsqu'il est correctement influencé par l'émetteur et pour lequel la broche Pᵢ est amenée à un état actif autorisant la centrale de commande à piloter le circuit de commande, soit un état bloqué lorsqu'il est incorrectement influencé par l'émetteur et pour lequel la broche Pᵢ est amenée à un état inactif interdisant à la centrale de commande de piloter ledit circuit de commande.

De tels systèmes de détection, dans lesquels le capteur peut être une cellule à effet HALL, ou un récepteur infrarouge ou une bobine oscillante, sont généralement utilisés pour commander des dispositifs de sécurité, ou pour piloter des circuits de commande d'appareils électriques en fonction de la présence ou non de l'émetteur ; par exemple, un capteur à effet HALL a déjà été utilisé dans des robots culinaires à fonctions multiples. Dans l'une ou l'autre de ces utilisations, le fonctionnement du système de détection repose entièrement sur la fiabilité du capteur.

Un tel dispositif est divulgué dans EP-A-0 440 051.

Malheureusement, il s'avère que dans certains cas, ces composants présentent des anomalies au niveau de la cellule HALL, ou de la cellule infrarouge et/ou du transistor de sortie et viennent à prendre de façon permanente leur état passant quelque soit l'influence de l'émetteur. Ainsi le système de détection devient inefficace dans toutes ses applications et notamment celles de sécurité et peut même occasionner, lorsqu'il est utilisé sur un appareil électrique tel qu'un robot culinaire, des blessures à l'usager qui est trompé sur le fonctionnement de l'appareil.

L'invention a donc pour but d'éliminer ces inconvénients et de rendre fiable le fonctionnement de ces systèmes de détection.

Selon l'invention, le système de détection comporte un dispositif de vérification du bon fonctionnement du capteur qui comprend un circuit de commande additionnel relié, d'une part, au capteur, et, d'autre part, à une autre broche dite P_{c} de la centrale de commande, ainsi que dans la centrale de commande un générateur-programmeur qui commande à intervalles de temps l'envoi sur ladite broche P_{c} d'un signal d'activation du circuit de commande additionnel forçant le capteur à prendre son état bloqué, et qui analyse l'état instantané correspondant de la broche Pᵢ en fonction de l'état de la broche P_{c} de manière à interdire à la centrale de commande le pilotage du circuit de commande si cet état instantané est différent de l'état inactif.

Grâce à ce dispositif de vérification, on est certain que quelque soit l'état de fonctionnement du capteur, détérioré ou non, la centrale de commande ne pourra pas piloter le circuit de commande, même en présence de l'émetteur ou de l'objet à détecter, aussi longtemps que la comparaison effectuée à intervalles de temps concluera à l'incompatibilité entre le signal d'activation sur la broche P_{c} et l'état de la broche Pᵢ subordonné au capteur qui doit prendre sous cette activation son état bloqué.

Les caractéristiques et avantages de l'invention ressortiront d'ailleurs de la description qui va suivre, à titre d'exemple, en référence aux dessins annexés dans lesquels :

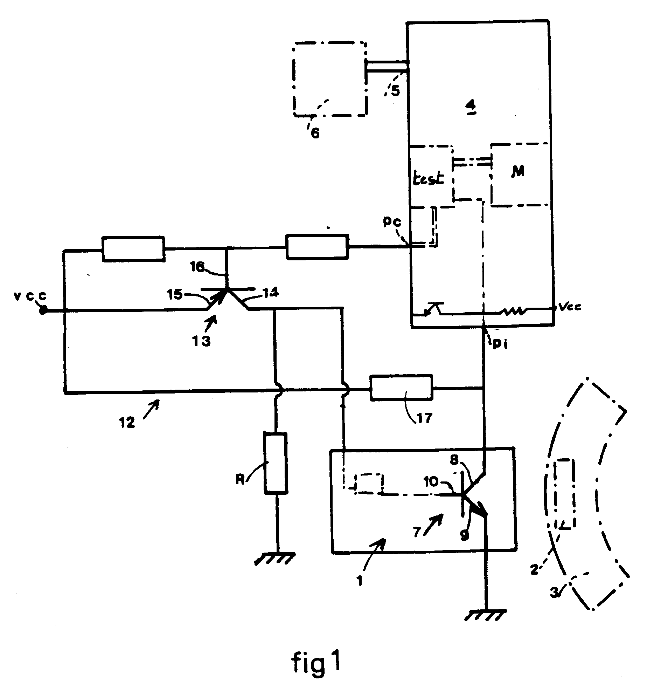

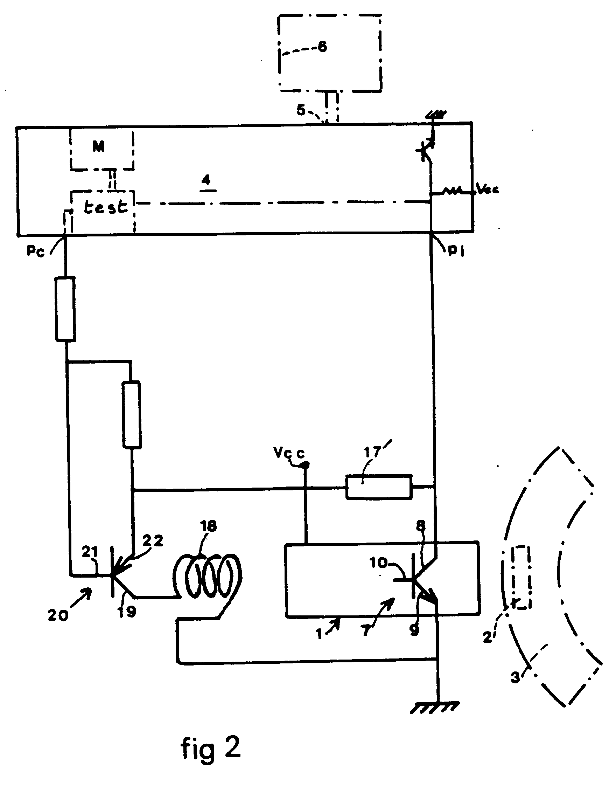

la figure 1 représente un schéma du système de détection selon la présente invention et selon une première forme de réalisation ; la figure 2 est un schéma d'une seconde forme de réalisation du système de détection selon l'invention.

Comme représenté aux figures 1 et 2, le système de détection est utilisé, à titre d'exemple préférentiel, avec un capteur 1 à effet HALL commandé par un émetteur à champ magnétique tel que, par exemple, celui d'un aimant 2, et adapté à piloter un circuit de commande d'un appareil électrique du type par exemple robot culinaire. Un tel robot culinaire a été décrit dans la demande de brevet français n° 90 00 930 déposée le 26 janvier 1990 au nom de la Demanderesse. Dans un tel robot, le capteur 1 à effet HALL est monté dans le boîtier, tandis que l'aimant 2 est monté dans le bol de travail et/ou dans le couvercle 3 dudit bol.

Le circuit de commande de l'appareil comporte une centrale de commande telle que, par exemple de façon connue en soi, un microcontrôleur 4 dont certaines broches 5 sont reliées à une interface 6 de commande du moteur du robot et dont une des broches d'entrée-sortie dite PI est reliée au capteur 1. Comme schématisé en traits interrompus, le microcontrôleur 4 du type, par exemple, 8051 de la société INTEL comporte une mémoire morte M et dans son circuit interne de branchement des broches d'entrée-sortie dites ports un équivalent électrique comportant un transistor du type NPN relié, d'une part, à la masse, et, d'autre part, à une source V_{cc} par une résistance ainsi qu'à ladite broche Pᵢ.

Ce capteur 1 à effet HALL comporte un transistor de sortie 7 du type NPN dont le collecteur 8 est relié à la borne Pᵢ du microcontrôleur et dont l'émetteur 9 est relié à la masse du circuit, tandis que la base 10 est alimentée via une électronique interne au capteur, par une source de courant continu V_{cc}. Le transistor de sortie 7 peut prendre soit un état passant dit saturé lorsque le capteur est correctement influencé par le champ magnétique, c'est-à-dire dans le cas présent par la présence de l'accessoire et/ou la fermeture correcte du bol par le couvercle, et pour lequel la broche Pᵢ est amenée à un état actif ou bas autorisant le microcontrôleur 4 à piloter le circuit de commande, soit un état bloqué lorsque le capteur n'est pas correctement influencé par le champ magnétique, c'est-à-dire en l'absence du bol et/ou du couvercle, et pour lequel la broche Pᵢ est amenée à un état inactif ou haut interdisant au microcontrôleur 4 de piloter ledit circuit de commande. La source de courant continu utilisée présente un potentiel dit haut de 5 volts et un potentiel dit bas correspondant à la masse du circuit.

Selon l'invention, le système de détection comporte un dispositif de vérification du bon fonctionnement du capteur 1 à effet HALL qui comprend un circuit de commande additionnel relié, d'une part, au capteur 1, et, d'autre part, à une autre broche d'entrée-sortie dite P_{c} du microcontrôleur 4, ainsi qu'un générateur-programmeur associé à un programme de test installé dans la mémoire morte M dudit microcontrôleur, ledit programme de test commandant à intervalles de temps l'envoi sur ladite broche P_{c} d'un signal d'activation du circuit de commande additionnel 12 forçant le capteur 1 à prendre son état bloqué, et analysant l'état instantané correspondant de la broche Pᵢ de manière à interdire au microcontrôleur le pilotage du circuit de commande si cet état instantané est différent de l'état inactif. Le programme test se déroule selon des intervalles réguliers par exemple de 20 millisecondes, ou selon des intervalles aléatoires.

Grâce à ce dispositif de vérification, le circuit de commande additionnel est activé par le programme test et vérifie à intervalles de temps périodiques ou aléatoires le bon fonctionnement du capteur, c'est à dire des éléments internes tels que la cellule HALL et/ou le transistor de sortie de manière à éviter toute fausse commande du circuit de commande de l'appareil électrique par le microcontrôleur.

Selon un mode de réalisation préféré de l'invention illustré à la figure 1, le circuit de commande additionnel 12 comprend un interrupteur électronique 13 du type à transistor PNP dont la sortie 14 dite collecteur est reliée à la masse du circuit via une résistance R ainsi qu'au capteur 1, donc, via un circuit interne au capteur, à la base 10 du transistor de sortie 7, et dont l'entrée 15 dite émetteur est reliée à la source d'alimentation continue V_{cc}, tandis que la base 16 est reliée par un pont diviseur à la broche P_{c} du microcontrôleur 4. En outre, la broche Pᵢ du microcontrôleur est reliée à la source V_{cc} via une résistance 17 limitatrice de courant.

Le fonctionnement va maintenant être décrit selon deux phases, une première phase correspondant au fonctionnement normal avec le capteur 1 non détérioré, et une seconde phase correspondant à un fonctionnement anormal avec le capteur 1 détérioré.

Selon la première phase de fonctionnement, on suppose le couvercle 3 et/ou le bol correctement mis en place et l'aimant 2 influençant directement le capteur 1 à effet HALL. Le transistor de sortie est saturé et la broche Pᵢ est à son état actif ou bas en étant mis à la masse. Le microcontrôleur 4 est donc autorisé à piloter le fonctionnement de l'appareil par l'interface 6 et donc dans le cas du robot culinaire à mettre en marche le moteur et à commander sa vitesse.
Si l'on vient à enlever le bol et/ou le couvercle 3, le capteur 1 n'étant plus influencé par l'aimant 2, le transistor de sortie 7 est bloqué et la broche Pᵢ est alimenté via la résistance limitatrice 17 par la source V_{cc} et se trouve à l'état inactif ou haut. Ainsi le microcontrôleur n'est pas autorisé à commander le circuit de commande de l'appareil et donc le fonctionnement du moteur.

Pendant le fonctionnement de l'appareil, le programme de test envoie, par exemple, toutes les 20 millisecondes un signal d'activation qui met la broche P_{c} à un état haut correspondant au potentiel de 5 volts. Le transistor 13 passe à son état bloqué puisque sa base 16 est alimentée, ce qui amène le transistor de sortie 7 en son état bloqué et donc la broche Pᵢ à son état haut. Le programme de test analyse l'état instantané de la broche Pᵢ, constate l'état inactif ou haut de la broche Pᵢ et conclut par comparaison avec l'état de la broche P_{c} que le capteur 1 à effet HALL n'est pas détérioré.

Selon la seconde phase de fonctionnement, on suppose que le couvercle et/ou le bol ne sont pas correctement mis en place et l'aimant 2 n'influence pas directement le capteur 1 à effet HALL, mais que la cellule HALL ou le transistor de sortie 7 est détérioré ce qui correspond à un court circuit. Dans ces conditions, le transistor de sortie 7 est dans son état saturé et la broche Pᵢ se trouve en son état bas et autorise normalement le pilotage du circuit de commande de l'appareil. Cependant, comme le programme test se déroule périodiquement toutes les 20 millisecondes et envoie sur la broche P_{c} un signal d'activation la faisant passer en son état haut, le transistor 13 est bloqué ce qui amène le transistor de sortie 7 également en son état bloqué puisqu'il ne reçoit plus de courant sur sa base 10 et donc la broche Pᵢ devrait être amenée à son état haut. Mais du fait de la détérioration de la cellule HALL et/ou du transistor de sortie correspondant à un court-circuit, la broche Pᵢ est reliée directement à la masse du circuit et se trouve à l'état bas. Par conséquent, le programme test constate l'inégalité entre les états des broches P_{c} et Pᵢ et conclut à la détérioration du capteur 1 en interdisant donc au microcontrôleur de piloter l'appareil.

Selon une variante de réalisation de l'invention illustrée à la figure 2, le circuit de commande additionnel comporte outre le programme test, une bobine schématisée en 18 qui est agencée derrière le capteur 1 à effet HALL et qui est adaptée à produire un champ magnétique au moins égal à celui de l'aimant 2 et opposé à celui de l'aimant. Ladite bobine 18 est reliée, d'une part, à la masse du circuit, et, d'autre part, au collecteur 19 d'un interrupteur électronique 20 du type transistor PNP dont la base 21 est en liaison par un pont diviseur avec la broche P_{c} du microcontrôleur 4. Quant à la broche Pᵢ du microcontrôleur 4, celle-ci est reliée à la fois au collecteur 8 du transistor de sortie 7 et via une résistance 17' à une source de courant continu V_{cc} également reliée au capteur 1 et à l'émetteur 22 du transistor 20. Ainsi, la broche Pᵢ est amenée à son état haut correspondant pratiquement à la tension V_{cc} lorsque le transistor 7 est en son état bloqué.

On va maintenant décrire le fonctionnement de cette variante uniquement dans le cas où le capteur 1 à effet HALL est détérioré. Dans cette réalisation, le programme test se déroulant par exemple toutes les 20 millisecondes envoie sur la broche P_{c} un signal d'activation la faisant passer en son état bas. Le transistor 20 est saturé et la bobine 18 est alimentée créant ainsi un champ magnétique au moins égale et contraire à celui de l'aimant 2 de manière à annuler le champ de l'aimant 2. Le capteur 1 devrait, dans cette condition forcée, être bloqué et amener la broche Pᵢ à son état inactif ou haut. Mais au contraire, la broche Pᵢ, par le court-circuit du transistor de sortie 7, est à son état actif ou bas directement relié à la masse. Le programme test conclu par comparaison instantanée avec l'état de la broche P_{c} à la détérioration du capteur 1.

Ainsi le procédé de mise en oeuvre du dispositif de vérification du bon fonctionnement du capteur consiste à envoyer sur la broche P_{c} du microcontrôleur 4 au moyen d'un programme de test un signal d'activation correspondant à un certain potentiel ; à envoyer ce signal à un circuit de commande additionnel de manière à lui permettre de commander le capteur 1 ; à forcer ledit capteur à prendre son état bloqué ; à analyser l'état instantané actif ou inactif de la broche Pᵢ, c'est-à-dire son potentiel ; à le comparer au potentiel de la broche P_{c} ; et à conclure si l'état de la broche Pᵢ est compatible avec l'état d'activation de la broche P_{c} au bon fonctionnement du capteur 1, et dans le cas contraire à la détérioration du capteur.

Comme on le comprendra, ce dispositif de vérification du bon fonctionnement d'un capteur s'applique également à tous systèmes de sécurité comportant, par exemple, un capteur à infrarouge ou à bobine oscillante, et destinés à vérifier la présence ou la non présence d'un émetteur d'activation du capteur concerné.

## Revendications

1. Système de détection ayant un capteur (1) commandé par un émetteur et comportant une centrale de commande électronique (4) dont certaines broches sont adaptées à piloter un circuit de commande et dont au moins une broche dite Pᵢ est reliée au capteur (1), ce capteur pouvant prendre, grâce à une source d'alimentation V_{cc}, soit un état passant lorsqu'il est correctement influencé par l'émetteur et pour lequel la broche Pᵢ est amenée à un état actif autorisant la centrale de commande (4) à piloter le circuit de commande, soit un état bloqué lorsqu'il est incorrectement influencé par l'émetteur et pour lequel la broche Pᵢ est amenée à un état inactif interdisant à la centrale de commande (4) de piloter ledit circuit de commande,
**caractérisé en ce qu'**il comporte un dispositif de vérification du bon fonctionnement du capteur qui comprend un circuit de commande additionnel (12) relié, d'une part, au capteur (1), et, d'autre part, à une autre broche dite P_{c} de la centrale de commande (4), ainsi que dans la centrale de commande (4) un générateur-programmeur qui commande à intervalles de temps l'envoi sur ladite broche P_{c} d'un signal d'activation du circuit de commande additionnel (12) forçant le capteur (1) à prendre son état bloqué, et qui analyse l'état instantané correspondant de la broche Pᵢ en fonction de l'état de la broche P_{c} de manière à interdire à la centrale de commande (4) le pilotage du circuit de commande si cet état instantané est différent de l'état inactif.

2. Système de détection selon la revendication 1,
**caractérisé en ce que** la centrale de commande électronique (4) comporte un microcontrôleur possédant une mémoire morte interne M, et la broche Pᵢ est susceptible d'être reliée à deux potentiels différents dont l'un est subordonné au capteur (1), tandis que le générateur-programmeur est associé à un programme de test installé dans ladite mémoire morte M.

3. Système de détection selon la revendication 1 ou 2,
**caractérisé en ce que** le circuit de commande additionnel (12) comprend un interrupteur électronique (13) qui est commandé par la broche P_{c}, dont la sortie (14) est reliée au capteur (1), et dont l'entrée (15) est reliée à une source d'alimentation continu V_{cc} qui est reliée également à la broche Pᵢ par une résistance limitatrice (17-17') de telle sorte que la broche Pᵢ est amenée à son état inactif correspondant pratiquement à la tension de la source V_{cc} lorsque le capteur (1) est en son état bloqué.

4. Système de détection selon l'une quelconque des revendications précédentes,
**caractérisé en ce que** le capteur (1) est un capteur à effet HALL et l'émetteur est constitué par un champ magnétique.

5. Système de détection selon l'une des revendications 2 à 4,
**caractérisé en ce que** le capteur (1) comprend un transistor de sortie (7) du type NPN dont l'émetteur (9) est relié à la masse du circuit, dont le collecteur (8) est relié à la borne Pᵢ, et dont la base (10) est en liaison avec la source V_{cc} via l'interrupteur électronique (13), et en ce que l'interrupteur électronique (13) est un transistor du type PNP dont l'émetteur (15) dit entrée et le collecteur (14) dit sortie sont reliés respectivement à la source V_{cc} et à ladite base (10) du transistor de sortie (7), et dont la base (16) est en liaison avec la broche P_{c} du microcontrôleur (4).

6. Système de détection selon la revendication 4,
**caractérisé en ce que** le circuit de commande additionnel comporte une bobine (18) qui est agencée derrière le capteur (1) à effet HALL et qui est adaptée à produire un champ magnétique opposé et au moins égal à celui qui influence correctement le capteur, ladite bobine(18) étant reliée, d'une part, à la masse du circuit, et, d'autre part, à la sortie (19) d'un interrupteur électronique (20) qui est commandé par la broche Pc de la centrale de commande (4) et dont l'entrée (22) est reliée à la source Vcc, et en ce que la broche Pᵢ est aussi reliée à la source Vcc et est amenée à son état inactif correspondant pratiquement à ladite tension V_{cc} lorsque le transistor de sortie (7) est en son état bloqué.

7. Système de détection selon la revendication 6,
**caractérisé en ce que** le transistor de sortie (7) du capteur étant du type NPN dont l'émetteur (9) est relié à la masse du circuit, l'interrupteur électronique (20) est un transistor du type PNP dont la base(21) est en liaison avec la borne P_{c} du microcontrôleur et dont la sortie(19) est constituée par le collecteur.

8. Système de détection selon l'une quelconque des revendications précédentes,
**caractérisé en ce que** le signal d'activation est émis sur la broche P_{c} par le générateur-programmeur selon un cycle de 20 millisecondes.

9. Système de détection selon l'une quelconque des revendications précédentes,
**caractérisé en ce que** le champ magnétique influençant normalement le capteur est créé par un aimant (2).

10. Procédé de mise en oeuvre du fonctionnement du système de détection selon l'une quelconque des revendications 2 à 7,
**caractérisé en ce que** l'on envoie sur la broche P_{c} du microcontrôleur (4), au moyen d'un programme de test, un signal d'activation correspondant à un certain potentiel ; on envoie ledit signal d'activation à un circuit de commande additionnel de manière à lui permettre de commander le capteur (1) pour faire prendre à ce dernier son état bloqué ; on analyse l'état instantané actif ou inactif de la broche Pᵢ, c'est-à-dire son potentiel ; on compare, au moyen du programme de test, les états des broches P_{c} et Pᵢ ; et on conclut si l'état de la broche Pᵢ est compatible avec l'état d'activation de la broche P_{c} au bon fonctionnement du capteur, et dans le cas contraire à la détérioration du capteur.

## Claims

1. Detection system having a sensor (1) controlled by an emitter and having an electronic control unit (4), certain pins of which are adapted to drive a control circuit and at least one pin of which, referred to as Pᵢ, is connected to the sensor (1), this sensor being able to take, by virtue of a power supply source V_{cc}, either a conducting state when it is correctly influenced by the emitter and in which the pin Pᵢ is brought to an active state enabling the control unit (4) to drive the control circuit, or a non-conducting state when it is incorrectly influenced by the emitter and in which the pin Pᵢ is brought to an inactive state preventing the control unit from driving the said control circuit, characterised in that it has a device for checking the correct functioning of the sensor, which comprises an additional control circuit (12) connected on the one hand to the sensor (1) and on the other hand to another pin, referred to as P_{c}, of the control unit (4), as well as, in the control unit (4), a generator/programmer which at intervals of time controls the sending, over the said pin P_{c}, of a signal activating the additional control circuit (12) forcing the sensor (1) to take its off state, and which analyses the corresponding instantaneous state of the pin Pᵢ according to the state of the pin P_{c} so as to prevent the control unit from driving the control circuit (4) if this instantaneous state is different from the inactive state.

2. Detection system according to Claim 1, characterised in that the electronic control unit (4) has a microcontroller having an internal read only memory M, and the pin Pᵢ is able to be connected to two different potentials, one of which is dependent on the sensor (1), whilst the generator/programmer is associated with a test program installed in the said read only memory M.

3. Detection system according to Claim 1 or 2, characterised in that the additional control circuit (12) comprises an electronic switch (13) which is controlled by the pin P_{c}, whose output (14) is connected to the sensor (1), and whose input (15) is connected to a DC supply source V_{cc} which is also connected to the pin Pᵢ by a limiting resistor (17-17') so that the pin Pᵢ is brought to its inactive state corresponding practically to the voltage of the source V_{cc} when the sensor (1) is in its off state.

4. Detection system according to any one of the preceding claims, characterised in that the sensor (1) is a Hall-effect sensor and the emitter consists of a magnetic field.

5. Detection system according to one of Claims 2 to 4, characterised in that the sensor (1) comprises an output transistor (7) of the npn type whose emitter (9) is connected to the earth of the circuit, whose collector (8) is connected to the terminal Pᵢ, and whose base (10) is in connection with the source V_{cc} via the electronic switch (13) and in that the electronic switch (13) is a transistor of the pnp type whose emitter (15), referred to as the input, and whose collector (14), referred to as the output, are connected respectively to the source V_{cc} and to the said base (10) of the output transistor (7), and whose base (16) is in connection with the pin P_{c} of the microcontroller (4).

6. Detection system according to Claim 4, characterised in that the additional control circuit includes a coil (18) which is arranged behind the Hall-effect sensor (1) and which is adapted to produce a magnetic field opposite to and at least equal to that which correctly implements the sensor, the said coil (18) being connected on the one hand to the earth of the circuit and on the other hand to the output (19) of an electronic switch (20) which is controlled by the pin P_{c} of the control unit (4) and whose input (22) is connected to the source V_{cc}, and in that the pin Pᵢ is also connected to the source V_{cc} and is brought to its inactive state corresponding practically to the said voltage V_{cc} when the output transistor (7) is in its off state.

7. Detection system according to Claim 6, characterised in that the output transistor (7) of the sensor being of the npn type, whose emitter (9) is connected to the earth of the circuit, the electronic switch (20) is a transistor of the pnp type whose base (21) is in connection with the terminal P_{c} of the microcontroller and whose output (19) consists of the collector.

8. Detection system according to any one off the preceding claims, characterised in that the activation signal is emitted on the pin P_{c} by the generator/programmer in a cycle of 20 milliseconds.

9. Detection system according to any one of the preceding claims, characterised in that the magnetic field normally influencing the sensor is created by a magnet (2).

10. Method of implementing the functioning of the detection system according to any one of Claims 2 to 7, characterised in that an activation signal corresponding to a certain potential is sent over the pin P_{c} of the microcontroller (4), by means of a test program; the said activation signal is sent to an additional control circuit so as to enable it to control the sensor (1) in order to cause the latter to take its off state; the instantaneous active or inactive state off the pin Pᵢ, that is to say its potential, is analysed; the states of the pins P_{c} and Pᵢ are compared by means of the test program; and it is concluded, if the state of the pin Pᵢ is compatible with the state of activation of the pin P_{c}, that the sensor is functioning correctly, and in the contrary case that the sensor is damaged.

## Patentansprüche

1. Erfassungssystem mit einern Sensor (1), der von einem Emitter gesteuert wird, und das eine elektronische Steuerzentrale (4) aufweist, von der bestimmte Kontakte dazu geeignet sind, eine Steuerschaltung zu regeln, und von denen wenigstens ein Kontakt, der Pᵢ heißt, mit dem Sensor (1) verbunden ist, wobei dieser Sensor dank einer Versorgungsquelle V_{cc} entweder einen Durchlaßzustand annehmen kann, wenn er von dem Emitter korrekt beeinflußt wird, und für den der Kontakt Pᵢ in einen aktiven Zustand gebracht wird, der die Steuerzentrale (4) autorisiert, die Steuerschaltung zu regeln, oder einen Sperrzustand, wenn er von dem Emitter inkorrekt beeinflußt wird, und für den der Kontakt Pᵢ in einen inaktiven Zustand gebracht wird, der der Steuerzentrale (4) untersagt, die Steuerschaltung zu regeln,
**dadurch gekennzeichnet, daß** es eine Einrichtung zum Überprüfen der guten Funktionstüchtigkeit des Sensors, die eine zusätzliche Steuerschaltung (12) umfaßt, die einerseits mit dem Sensor (1) und andererseits mit einem weiteren Kontakt der Steuerzentrale (4), dem sogenannten P_{c} verbunden ist, sowie in der Steuerzentrale (4) einen Programmgenerator aufweist, der in Zeitintervallen das Senden eines Signals zur Aktivierung der zusätzlichen Steuerschaltung (12) an dem Kontakt P_{c} steuert, wodurch der Sensor (1) gezwungen wird, seinen Sperrzustand einzunehmen, und der den entsprechenden Momentanzustand des Kontakts Pᵢ in Abhängigkeit vom Zustand des Kontakts P_{c} analysiert, um der Steuerzentrale (4) die Regelung der Steuerschaltung zu untersagen, wenn sich dieser Momentanzustand von dem inaktiven Zustand unterscheidet.

2. Erfassungssystem nach Anspruch 1,
**dadurch gekennzeichnet, daß** die elektronische Steuerzentrale (4) einen Mikrosteuerbaustein mit einem internen Festwertspeicher M aufweist und der Kontakt Pᵢ mit zwei unterschiedlichen Potentialen verbunden werden kann, von denen eines dem Sensor (1) untergeordnet ist, während der Programmgenerator einem Testprogramm zugeordnet ist, das in dem Festwertspeicher M installiert ist.

3. Erfassungssystem nach Anspruch 1 oder 2,
**dadurch gekennzeichnet, daß** die zusätzliche Steuerschaltung (12) einen von dem Kontakt P_{c} gesteuerten elektronischen Schalter (13) aufweist, dessen Ausgang (14) mit dem Sensor (1) verbunden ist und dessen Eingang (15) mit einer Gleichstromversorgungsquelle V_{cc} verbunden ist, die über einen Begrenzerwiderstand (17-17') auch mit dem Kontakt Pᵢ derart verbunden ist, daß der Kontakt Pᵢ in seinen inaktiven Zustand gebracht wird, der praktisch der Spannung der Quelle Vcc entspricht, wenn der Sensor (1) in seinem Sperrzustand ist.

4. Erfassungssystem nach einem der vorhergehenden Ansprüche,
**dadurch gekennzeichnet, daß** der Sensor (1) ein Halleffekt-Sensor ist und der Emitter von einem Magnetfeld gebildet ist.

5. Erfassungssystem nach einem der Ansprüche 2 bis 4,
**dadurch gekennzeichnet, daß** der Sensor (1) einen Ausgangstransistor (7) vom Typ npn aufweist, dessen Emitter (9) mit der Masse der Schaltung verbunden ist, dessen Kollektor (8) mit dem Kontakt Pᵢ verbunden ist, und dessen Basis (10) über den elektronischen Schalter (13) mit der Quelle V_{cc} in Verbindung steht, und daß der elektronische Schalter (13) ein pnp-Transistor ist, dessen Emitter (15), der sogenannte Eingang, und Kollektor (14), der sogenannte Ausgang, mit der Quelle V_{cc} bzw. der Basis (10) des Ausgangstransistors (7) verbunden sind und dessen Basis (16) mit dem Kontakt P_{c} des Mikrosteuerbausteins (4) in Verbindung steht.

6. Erfassungssystem nach Anspruch 4,
**dadurch gekennzeichnet, daß** die zusätzliche Steuerschaltung eine Spule (18) aufweist, die hinter dem Halleffekt-Sensor (1) angeordnet und dazu geeignet ist, ein Magnetfeld zu erzeugen, das demjenigen entgegengesetzt und wenigstens gleich ist, das den Sensor korrekt beeinflußt, wobei die Spule (18) einerseits mit der Masse der Schaltung und andererseits mit dem Ausgang (19) eines elektronischen Schalters (20) verbunden ist, der von dem Kontakt P_{c} der Steuerzentrale (4) gesteuert wird und dessen Eingang (22) mit der Quelle V_{cc} verbunden ist, und daß der Kontakt Pᵢ auch mit der Quelle V_{cc} verbunden ist und in seinen inaktiven Zustand gebracht ist, der praktisch der Spannung V_{cc} entspricht, wenn der Ausgangstransistor (7) in seinem Sperrzustand ist.

7. Erfassungssystem nach Anspruch 6,
**dadurch gekennzeichnet, daß** der Ausgangstransistor (7) des Sensors ein npn-Transistor ist, dessen Emitter (9) mit der Masse der Schaltung verbunden ist, und der elektronische Schalter (20) deshalb ein pnp-Transistor ist, dessen Basis (21) mit dem Kontakt P_{c} des Mikrosteuerbausteins in Verbindung steht und dessen Ausgang (19) durch den Kollektor gebildet ist.

8. Erfassungssystem nach einem der vorhergehenden Ansprüche,
**dadurch gekennzeichnet, daß** das Aktivierungssignal von dem Programmgenerator an dem Kontakt P_{c} gemäß einem Zyklus von 20 Millisekunden ausgesendet wird.

9. Erfassungssystem nach einem der vorhergehenden Ansprüche,
**dadurch gekennzeichnet, daß** das den Sensor normalerweise beeinflussende Magnetfeld von einem Magneten (2) erzeugt wird.

10. Verfahren zur Durchführung des Betriebs des Erfassungssystems nach einem der Ansprüche 2 bis 7,
**dadurch gekennzeichnet, daß** mittels eines Testprogramms an den Kontakt P_{c} des Mikrosteuerbausteins (4) ein Aktivierungssignal geschickt wird, das einem bestimmten Potential entspricht; das Aktivierungssignal zu einer zusätzlichen Steuerschaltung geschickt wird, so daß diese den Sensor (1) steuern kann, damit dieser seinen Sperrzustand einnehmen kann; der aktive oder inaktive Momentanaustand des Kontakts Pᵢ, d.h. sein Potential analysiert wird; mittels des Testprogramms die Zustände der Kontakte P_{c} und Pᵢ verglichen werden und dann auf die gute Funktionstüchtigkeit des Sensors geschlossen wild, wenn der Zustand des Kontakts Pᵢ mit dem Aktivierungszustand des Kontakts P_{c} kompatibel ist, und im gegenteiligen Fall auf die Beschädigung des Sensors geschlossen wird.
